# EUROPEAN PATENT APPLICATION

(11) **EP 4 517 343 A1**
(43) Date of publication of application: **05.03.2025**
(21) Application number: 24191838.2
(22) Date of filing: 30.07.2024
(51) Int. Cl.: G01R 27/20

(54) **METHOD FOR DETERMINING A GROUNDING RESISTANCE, GROUNDING RESISTANCE SURVEILLANCE SYSTEM AND MEASUREMENT DEVICE**

(30) Priority: 02.08.2023 IN 202311052071
(71) Applicant: DEHN SE, 92318 Neumarkt i.d. OPf. (DE)
(72) Inventor: ALMADI, Vikas, 122050 Gurugram, Haryana (IN); SAINI, Sunil, 122050 Gurugram, Haryana (IN); SHARMA, Vinay Kumar, 122050 Gurugram, Haryana (IN); TYAGI, Himanshu, 122050 Gurugram, Haryana (IN)
(74) Representative: Prinz & Partner mbB

(57) **Abstract**

A grounding resistance surveillance system (10) comprises a plurality of measurement devices (12, 14, 16, 18, 20, 22) configured for measuring a grounding resistance value and being arrangeable at different locations within a target area (24), and at least one gateway device (34, 36). Each of the plurality of gateway devices (34, 36) is communicatively coupled to at least one further measurement device (12, 14, 16, 18, 20, 22) of the plurality of measurement devices (12, 14, 16, 18, 20, 22), and at least one measurement device (12, 14, 16, 18, 20, 22) of the plurality of measurement devices (12, 14, 16, 18, 20, 22) is in direct communication to the at least one gateway device (34, 36) and at least one measurement device (12, 14, 16, 18, 20, 22) of the plurality of measurement devices (12, 14, 16, 18, 20, 22) is only in indirect communication to the at least one gateway device (34, 36) such that a mesh network of coupled measurement devices (12, 14, 16, 18, 20, 22) is formed. The grounding resistance surveillance system (10) is configured to execute a method for determining a grounding resistance in the target area (24).

Further, a measurement device (12, 14, 16, 18, 20, 22) for a grounding resistance surveillance system (10) is described.

## Description

The invention relates to a method for determining a grounding resistance in a target area, a grounding resistance surveillance system and a measurement device for measuring a grounding resistance value.

Lightning protection systems of structures like buildings typically have three main parts, namely an air termination system, a down conductor and an earth termination system. When a lightning strike hits the lightning protection system, the resulting lightning current is conducted from the air termination system through the down conductor to the earth termination system into the ground. The performance of the earth termination system is crucial for ensuring that the lightning current is effectively dissipated.

One determining factor for the effectiveness of the lightning protection system is the grounding resistance at the location in which the earth termination system enters the ground or soil. The grounding resistance is subject to changes over time, e.g. due to environmental influences like rain or sunshine and due to aging effects of the earth termination system. Thus, for assessing the effectiveness of the lightning protection systems over its lifetime, it is necessary to determine the grounding resistance after a pre-determined time interval.

If a multitude of lightning production systems are to be supervised which are distributed over extended areas, e.g. in industry plants or facilities, the necessary measurements of the grounding resistance are time- and labor intensive.

From CN 215 813 045 U, a grounding resistance detection system for supervising an oilfield well site is known. The system comprises a multitude of grounding resistance monitoring devices capable of measuring a grounding resistance of an associated grounding body. Each of the grounding resistance monitoring devices send the obtained measured values via a common gateway to an upper host through which an operator can control the operation of the system. In this way, the operator does not need to operator each of the monitoring devices one by one. However, all of the monitoring devices need to be able to communicate with the common gateway for communication with the upper host which limits the possible arrangement of the monitoring devices within the oilfields and/or makes it necessary to use communication modules with high power consumption.

It is an object of the invention to provide a method for determining a grounding resistance in an easy, flexible and automated manner. Further, it is an object of the invention to provide a grounding resistance surveillance system that enables a reliable long-time grounding resistance measurement.

The object of the invention is solved by a method for determining a grounding resistance in a target area, the method comprising the following steps:
a) Providing a grounding resistance surveillance system with a plurality of measurement devices configured for measuring a grounding resistance value and being arranged at different locations within the target area, and at least one gateway device, wherein each of the plurality of measurement devices is communicatively coupled to at least one further measurement device of the plurality of measurement devices, and wherein at least one measurement device of the plurality of measurement devices is in direct communication with the at least one gateway device and at least one measurement device of the plurality of measurement devices is only in indirect communication with the at least one gateway device such that a mesh network of coupled measurement devices is formed;
b) Measuring a grounding resistance value by each of the plurality of measurement devices at a pre-determined time stored in a control module of the respective measurement device;
c) Forwarding the measured grounding resistance values to the gateway device;
d) Forwarding, by the gateway device, an updated pre-determined time to the plurality of measurement devices; and
e) Repeating steps b) to d) at least once with the pre-determined time being the updated pre-determined time.

The invention is based on the idea to provide a mesh network of multiple measurement devices to determine the grounding resistance at a plurality of locations throughout the target area. At the same time, not every single measurement device within the mesh network needs to have a direct communication link with an associated gateway but can use the other measurement devices within the mesh network as relay stations for communication with the gateway device. Therefore, the measurement devices can be flexibly distributed throughout the target area, as not every single measurement device needs to be able to communicate with the gateway device directly, but only needs to be able to directly communicate with at least one further measurement device.

Here and in the following the expression "indirect communication" means that the respective devices in indirect communication are coupled via at least one further measurement device.

Further, all of the measurement devices are measuring the grounding resistance value in a time-coordinated fashion at the pre-determined time. This facilitates the evaluation of the obtained grounding resistance values. To ensure that further measurements are also done in a time-coordinated fashion, the pre-determined time is updated after each measurement based on an instruction received from the at least one gateway device.

The communication between different measurement devices as well as between the measurement devices and the at least one gateway device is bidirectional, such that information can be forwarded from the measurement devices to the at least one gateway device and from the at least one gateway device to the measurement devices, respectively.

The connection between the measurement devices and the at least one gateway device can be realized wired or wireless. E.g., a measurement device can be connected to another measurement device and/or the gateway device by a radiofrequency connection (e.g. via RF 868 MHz), a mobile connection (e.g., via GSM/GPRS), local wireless network connections (e.g., based on LORA or an NB-IOT protocol) or a cable-based connection (e.g., using RS485 communication links).

Of course, it is also possible that some of the connections between the devices of the grounding resistance surveillance network are wired and some of the connections are wireless.

Which measurement devices in the mesh network are coupled to which other measurement devices and which measurement devices are coupled to a given gateway device within the grounding resistance surveillance system is especially determined such that the distance between directly coupled devices are minimized. This increases the reliability of the data transfer between the directly coupled devices. However, dependent on the structures in the target area, e.g. buildings or walls, the connection structure can also be chosen based on the strength of a direct connection between directly connected devices instead of the local proximity. Generally, the respective connections are flexible such that the direct and indirect connections may be altered if necessary.

The overall transmission pathway from a given measurement device to the associated gateway device thus can be realized by a relay-like communication path using at least one further measurement device.

To provide optimized time-synchronized grounding resistance values, the pre-determined time can be the same for all measurement devices of the grounding resistance surveillance system.

The grounding resistance surveillance system can further comprise a central computation device communicatively coupled to the at least one gateway device, wherein the measured grounding resistance values are sent by the at least one gateway device to the central computation device. In this way, the obtained grounding resistance values can be stored and/or analyzed within the central computation device, such that the at least one gateway device can be simplified regarding its computational capabilities.

Further, the central computation device can be a cloud-hosted system to allow a user of the grounding resistance surveillance system to easily access the central computation device, and thus the grounding resistance values received from the at least one gateway, via an internet- or network-based connection.

To reduce the number of active communication links, the measured grounding resistance values can be sent by the at least one gateway device to the central computation device only when a measured grounding resistance value has been received by the at least one gateway device from each of the plurality of measurement devices. Termed differently, a given gateway device can first collect a measured grounding resistance value for each of the measurement devices associated to that gateway device before establishing a transfer connection to the central computation device and sending the collected measurement data. In this way, the energy consumption of the gateway device can be further reduced.

For reducing the energy consumption of the plurality of measurement devices, the difference between the pre-determined time and the updated pre-determined time is flexible. For instance, the difference between the pre-determined time and the updated pre-determined can be 24 hours or more. A difference between the pre-determined time and the updated pre-determined time most preferably is 24 hours. Accordingly, the measurement devices only need to be active for a short duration per day, e.g. once per day, for measuring the grounding resistance, forwarding the measured grounding resistance to the at least one gateway device and receiving the updated pre-determined time from the associated gateway device.

The difference between the pre-determined time and the updated pre-determined time can be user-adaptable. For instance, the user can set the difference via the central computation device and the user setting is then sent from the central computation device to the at least one gateway device such that the at least one gateway device determines the updated pre-determined time based on the user setting.

Preferably, the measurement devices forward a confirmation message to the at least one gateway device when the updated pre-determined time has been received. This allows to assess whether the correct updated pre-determined time has actually reached all of the measurement devices in the grounding resistance surveillance system, such that situations in which some or all of the measured grounding resistance values are missing from a set of measurements taken at the updated pre-determined time can be avoided.

If the at least one gateway device does not receive a confirmation message for each of the associated measurement devices, the at least one gateway can send the updated pre-determined time again to ensure that all of the measurement devices have received the updated pre-determined time.

Preferably, the at least one gateway device comprises a seismic sensor for detecting seismic activity in the target area. If a magnitude of the seismic activity detected by the seismic sensor is larger than a magnitude threshold value stored in a memory of the gateway device, the at least one gateway device forwards an alarm signal to the plurality of measurement devices.

The measurement devices can, in response to receiving the alarm signal, stop measuring grounding resistance values until receiving a re-start signal from the at least one gateway device. The re-start signal can be forwarded by the gateway device after the magnitude of the seismic activity is lowered below the magnitude threshold value again and/or after a pre-determined seismic delay time after a seismic activity with a magnitude larger than the magnitude threshold value has been detected.

Thus, by providing the at least one gateway device with a seismic sensor, it is possible to avoid measurements which are affected by a seismic event in the target area. In this way, the reliability of the grounding resistance values obtained by the measurement devices can be further increased, even if the target area is located in a region with strong and/or frequent seismic activities.

This is especially advantageous if the grounding resistance values obtained by the measurement devices at different times are analyzed for possible changes over time, e.g. by the central computation device, as errors due to seismic activity can be avoided or at least minimized.

The object of the invention is further solved by a grounding resistance surveillance system comprising a plurality of measurement devices configured for measuring a grounding resistance value and being arrangeable at different locations within a target area, and at least one gateway device. Each of the plurality of gateway devices is communicatively coupled to at least one further measurement device of the plurality of measurement devices. At least one measurement device of the plurality of measurement devices is in direct communication to the at least one gateway device. At least one measurement device of the plurality of measurement devices is only in indirect communication to the at least one gateway device such that a mesh network of coupled measurement devices is formed. The grounding resistance surveillance system is configured to execute the above-described method.

Thus, the features and advantages of the method according to the invention also apply for the grounding resistance surveillance system and *vice versa.*

Each of the measurement devices can comprise an internal energy storage and/or is connectable to an external power source. Preferably, the measurement device is supplied with energy only by an internal energy storage.

If the measurement device only is supplied by an internal energy storage, the capacity of the internal energy storage is preferably chosen such that operation of the measurement device can be expected for at least one year without the need for exchanging the internal energy storage. This reduces the manual effort in terms of maintenance of the grounding resistance surveillance system.

The number of measurement devices associated with a single gateway device can be limited to a pre-determined group number. E.g., the pre-determined group number can be 128 or more, e.g. 255 measurement devices. Limiting the number of measurement devices avoids conflicts in the communication between a given gateway device and the associated measurement devices and limits the overall distance between the associated devices such that transmission times of information exchanged between the devices do not become too long. Further, the gateway device can be designed simpler in terms of its communication capabilities and therefore cheaper.

The gateway device can be connected to further components other than the measurement devices for determining earthing resistance. For instance, the further components can be additional sensor devices to obtain measurement data other than grounding resistance, e.g. temperature, humidity and/or pH values.

It is also possible that the measurement devices comprise additional sensor elements for obtaining measurement data other than grounding resistance, e.g. temperature, humidity and/or pH values, which can be forwarded to the gateway device together with grounding resistance values.

For protecting the measurement devices from environmental influences, the measurement device can comprise a waterproof housing.

The measurement devices can be free from user interfaces. Termed differently, a user of the grounding resistance surveillance system cannot access the measured grounding resistance values directly at the measurement devices. Instead, the measured grounding resistance values can only be evaluated in the at least one gateway device and/or the central computation device Thus, the measurement devices do not need to provide acoustic and/or graphical output to the user. In this way, the energy consumption of the measurement device is further lowered, such that a change of an internal energy storage is necessary less often and/or the capacity of the internal energy storage can be reduced.

To ensure that at least one gateway device can always be reached by the mesh network of measurement devices, at least one gateway device of the grounding resistance surveillance system can be connected to an external powers source. Thus, even in case in which an internal energy storage of all gateway devices of the grounding resistance surveillance system are depleted and therefore cannot power the respective gateway device anymore, each measurement device can reach at least the gateway device powered by the external power device over the mesh network of measurement devices. This is also true even if a longer relay path passing through additional measurement devices has to be chosen for forwarding and receiving data in this case.

In a similar manner, if multiple gateway devices are present in the grounding resistance measurement system, even in case of malfunctions of individual gateway devices, the measurement devices can forward the measured grounding resistance values to another one of the gateway devices by changing the used relay path.

The object of the invention is also solved by a measurement device for measuring a grounding resistance value for use in a grounding resistance surveillance system as described before.

The features and advantages of the grounding resistance surveillance system according to the invention are also true for the measurement device and *vice versa.*

Further advantages and features of the invention will become more apparent from the following description of preferred embodiments of the invention and from the Figures. In the Figures,
- Fig. 1 shows a schematic depiction of a grounding resistance surveillance system according to the invention with a plurality of measurement devices according to the invention, and
- Fig. 2 shows a block scheme of a method for determining a grounding resistance in a target area according to the invention using the grounding resistance surveillance system of Fig. 1.

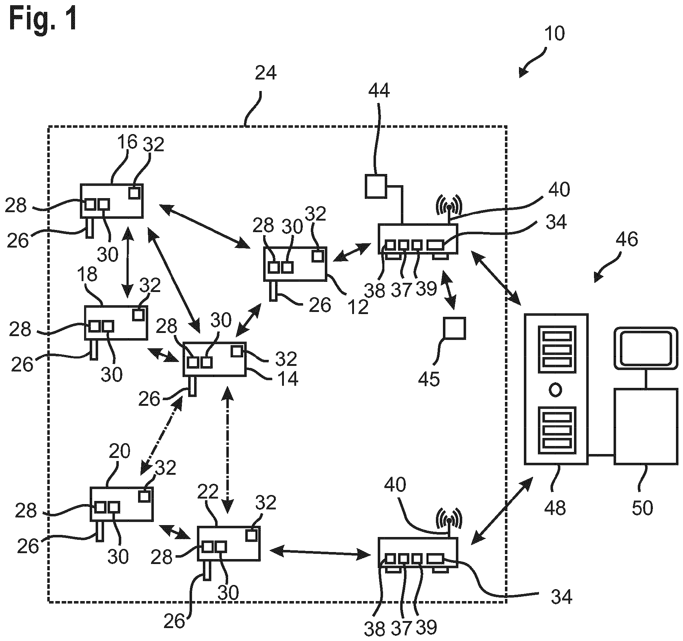

Fig. 1 shows a schematic depiction of a grounding resistance surveillance system 10 which comprises a plurality of measurement devices 12 to 22 distributed throughout a target area 24.

The target area 24 is an area to be surveilled by the grounding resistance surveillance system 10, e.g. a plant facility with one or more (not shown) plant structures which are protected by lightning protection systems, like a building. To each plant structure, at least one of the measurement devices 12 to 22 is associated.

Each of the measurement devices 12 to 22 comprises a grounding resistance sensor 26 capable of measuring a ground resistance value at the location at which the respective measurement device 12 to 22 is installed.

Further, each of the measurement devices 12 to 22 has a control module 28, an internal energy storage 30 and a communication module 32.

The control module 28 controls the operation of the respective measurement device 12 to 22. Especially, the control module 28 is configured to switch the control module 28 between an active mode and a sleep mode, wherein in the sleep mode some or all components of the measurement device 12 to 22 other than the control module 28 are disconnected from the internal energy storage 30. Thus, only the control module 28 and selected other components of the measurement device 12 to 22 needs to be powered by the internal energy storage 30 in the sleep mode, reducing the overall energy consumption of the measurement device 12 to 22.

In the active mode, the measurement device 12 to 22 can obtain ground resistance values via the ground resistance sensor 26 and communicate with further devices in the grounding resistance surveillance system 10 via the communication module 32.

In the control module 28, a pre-determined time is stored at which the control module 28 switches the measurement device 12 to 22 from the sleep mode in the active mode and takes a grounding resistance measurement, as will be described in more detail later on.

It is also possible that the measurement device 12 to 22 comprises one or more additional sensor elements other than the ground resistance sensor 26 for obtaining additional measurement values in the active mode. E.g., the additional sensor elements are configured to measure a pH, a temperature and/or a humidity value.

The measurement device 12 to 22 does not comprise any user interface like speakers or displays such that a user of the grounding system surveillance system 10 cannot directly access any data collected by the measurement device 12 to 22.

This allows to further minimize the energy consumption of the measurement device 12 to 22, such that an exchange of the internal energy storage 30 can be avoided as long as possible to reduce the amount of maintenance necessary to reliably run the grounding system surveillance system 10.

The grounding system surveillance system 10 further comprises two gateway devices 34 and 36.

Each gateway device 34 and 36 comprises a gateway control module 37, an internal gateway energy storage 38, a memory 39, a gateway communication module 40 and a seismic sensor 42.

The gateway control module 37 is configured to operate the other components of the gateway device 34, 36.

The gateway device 34 is further operably connected with an external power source 44 which is capable of providing the gateway device 34 with electricity such to be operable. That is, even in case the internal gateway energy storage 38 of the gateway device 34 is fully discharged, operation of the gateway device 34 is ensured by the external power source 44. In principle, the gateway device 34 could also have no internal gateway energy storage 38 and only rely on the power supply by the external power source 44. The external power source e.g. provides a voltage in the range of from 9 to 36 V.

In contrast, the gateway device 36 only comprises an internal gateway energy storage 38 but is not connected to an external power source. Thus, though the operation of the gateway device 36 can only be ensured by the internal gateway energy storage 38, the gateway device 36 can be more flexibly placed within the target area 24, as there is no need for a connection to an external power source.

It is also possible that one or all of the gateway devices 34, 36 are placed outside the target area 24, as long as at least one of the measurement devices 12 to 22 can still establish a direct communication link to the respective gateway device 34, 36.

In the shown embodiment, two gateway devices 34 and 36 are used. However, the grounding system surveillance system 10 can also only have a single gateway device, which preferably is the gateway device 34 connected to the external power source 44, or more than two gateway devices 34, 36.

Further, the grounding system surveillance system 10 can comprise more or less measurement devices 12 to 22 than shown in Fig. 1. The number of measurement devices 12 to 22 especially is dependent on the size of the target area 24 and/or the number of plant structures within the target area 24 which are to be protected against lightning strikes and therefore should be supervised in terms of the grounding resistance.

The measurement devices 12 to 22 are bi-directionally communicatively coupled to each other by the respective communication modules 32, as indicated by double-arrows in Fig. 1.

However, not every single measurement device 12 to 22 is directly coupled to each other measurement device 12 to 22. Instead, some of the measurement devices 12 to 22 are only indirectly coupled to each other, wherein at least one further measurement device can serve in a relay-like manner to enable communication between the indirectly coupled measurement devices.

E.g., measurement device 12 is directly coupled to measurement devices 14 and 16, but only indirectly coupled to measurement devices 18, 20 and 22.

Overall, the measurement devices 12 to 22 form a mesh network of measurement devices.

Further, the measurement device 12 is directly bi-directionally communicatively coupled to the gateway device 34 and the measurement device 22 is directly bi-directionally communicatively coupled to the gateway device 36, as is also indicated by the double-arrows in Fig. 1. More specifically, the respective communication modules 32 and gateway communication modules 40 are communicatively coupled.

In contrast, the measurement devices 14 to 20 are only indirectly bi-directionally communicatively coupled to the gateway devices 34 and 36, wherein at least one further measurement device serves as a relay station.

Of course, the number of directly and indirectly to the gateway devices 34, 36 coupled measurement devices 12 to 22 can be different than in the shown embodiment. However, according to the invention, at least one measurement device 12 to 22 is directly coupled to at least one of the gateway devices 34, 36 and at least one measurement device 12 to 22 is only indirectly coupled to the gateway devices 34, 36.

Further, the measurement devices 12 to 18 are generally associated to the gateway device 34, while the measurement devices 20 and 22 are generally associated to the gateway device 36. "Generally associated" here defines that the respective measurement devices preferentially communicate with the associated gateway device and only communicate with the other gateway device by using an altered relay path including further measurement devices, if the associated gateway device cannot be reached. This is indicated in Fig. 1 by the dot-dashed double arrows between the measurement device 14 and the measurement devices 20 and 22.

Thus, each of the gateway devices 34, 36 is responsible for an associated number of measurement devices. The maximum number of measurement devices associated to a single gateway device 34, 36 can be limited to a pre-determined group number, e.g. to a maximum of up to 255 different measurement devices.

Within the target area 24, further components can be arranged which are also communicatively coupled to the gateway device 34 and/or 36. In the embodiment shown in Fig. 1, an exemplary sensor device 45 configured to obtain measurement data other than grounding resistance values, e.g. temperature, humidity and/or pH values, is shown. The sensor device 45 is bi-directionally and communicatively coupled to the gateway device 34.

The grounding resistance surveillance system 10 further comprises a central computation device 46 which in the shown embodiment comprises a server unit 48 and a user interface 50.

The server unit 48, and therefore the central computation device 46, is bi-directionally communicatively coupled to each of the gateway devices 34 and 36, as indicated by double-arrows in Fig. 1.

The server unit 48 is located outside the target area 24 and provides e.g. an Internet-of-Things environment (IoT-environment) which is generally accessible via the internet and/or a local network structure, e.g. by the user interface 50.

In the following, the mode of action of the grounding system surveillance system 10 will be described in the framework of a method for determining the grounding resistance in the target area 24.

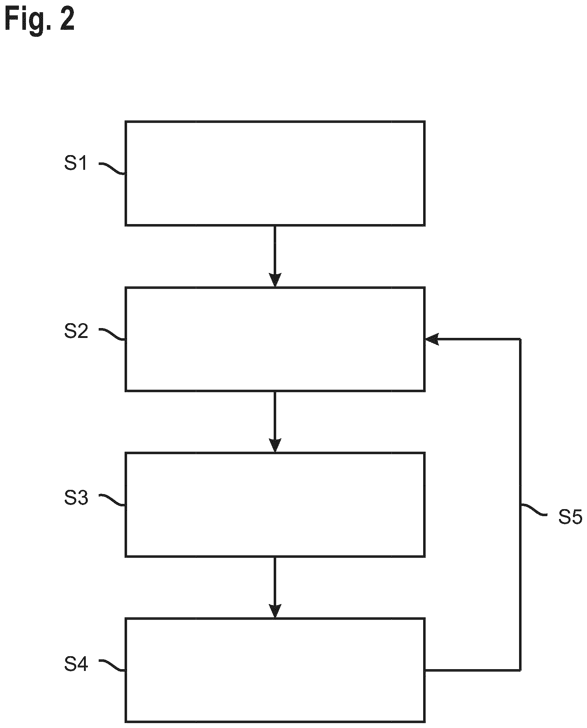

First, the grounding resistance surveillance system 10 as described before is provided, wherein the measurement devices 12 to 22 are placed distributed throughout the target area 24 (step S1 in Fig. 2).

E.g., the measurement devices 12 to 22 are each connected to a (not shown) main earthing connection of the plant structure the respective measurement device 12 to 22 is associated to.

Within the control module 28 of each of the measurement devices 12 to 22, a pre-determined time is stored at which a first measurement of the grounding resistance value at the location of the measurement devices 12 to 22 is to be started.

The pre-determined time can be set by the user of the grounding resistance surveillance system 10 via the user interface 50 and then forwarded via the gateway device 34, 36 to each of the measurement devices 12 to 22. Thus, each of the measurement devices 12 to 22 receives the same pre-determined time.

For synchronizing the operation of the measurement devices 12 to 22, the control module 28 of the measurement devices 12 to 22 can comprise a real-time clock (RTC). If further synchronization is necessary, the RTCs of all measurement devices 12 to 22 can be coordinated by the server unit 48 acting as NTP server (network time protocol server).

At the pre-determined time, each of the plurality of measurement devices 12 to 22 measures a grounding resistance value (step S2 in Fig. 2).

For this, the control module 28 switches the measurement device 12 to 22 from its sleep mode to its active mode such that the grounding resistance value can be measured via the grounding resistance sensor 26.

The grounding resistance value can be determined by any known method for determining a grounding resistance, e.g. a 3-pole method. Preferably, the measurement does not exceed a measurement time of one minute such to reduce the time in which the measurement device 12 to 22 needs to be in the active mode as much as possible.

The obtained measured grounding resistance value is then forwarded to the gateway device 34, 36 associated to the respective measurement device 12 to 22 (step S3 in Fig. 2).

However, the communication path for a given measurement device 12 to 22 used for forwarding the measured grounding resistance value depends on its position within the mesh network of measurement devices 12 to 22.

Measurement devices 12 and 22 are directly coupled to the gateway device 34 and 36, respectively, and thus can directly send the measured grounding resistance value to the respective gateway device 34 and 36.

In contrast, measurement devices 14 to 20 are only indirectly coupled to any of the gateway devices 34 and 36 and thus forward the measured grounding resistance values over a relay path to the associated gateway device 34 to 36.

E.g., measurement device 18 sends its measured grounding resistance value to measurement device 14, which in turn sends both the measured grounding resistance value of measurement device 14 and the measured grounding resistance value of measurement device 18 to measurement device 12. Measurement device 12 then sends all of the received measured grounding resistance values to the gateway device 34.

The relay path chosen by any given measurement device 14 to 20 can be chosen according to the proximity of the measurement devices 12 to 22 to each other, the signal strength of the communication link between the measurement devices 12 to 22 and/or the gateway device 34, 36 to which the respective measurement device 14 to 20 is associated.

The chosen relay path does not necessarily correspond to the overall shortest distance between two given measurement devices 12 to 22. Termed differently, the overall relay path can be longer than the shortest distance. E.g., measurement device 16 can use a relay path including measurement devices 18, 14 and 12 instead of a relay path in which measurement device 16 directly communicates with measurement device 12. Due to the meshed structure of the mesh network, the grounding resistance surveillance system 10 provides a high flexibility in the communication and relay pathways actually used for forwarding data.

Together with the grounding measurement value, at least one additional information can be forwarded by the respective measurement device 12 to 22. The additional information can include a measurement device identifier, a status of the internal energy storage 30, a time-stamp and/or a relay path identifier.

The gateway devices 34 and 36 collect the measured grounding resistance values and send the measured grounding resistance values to the central computation device 46.

Preferably, the gateway device 34, 36 waits for sending the measured grounding resistance values until the gateway device 34, 36 has received a measured grounding resistance value for each of the measurement devices 12 to 22 associated to the respective gateway device 34, 36. Thus, the gateway device 34, 36 only needs one data transfer to the central computation device 46, such that the energy consumption of the gateway device 34 and 36 can be minimized.

If any additional values like additional sensor values have been collected by the measurement devices 12 to 22 and/or the sensor device 45, these values are also sent by the gateway device 34, 36 to the central computing unit 46, preferably together with the measured grounding resistance values.

The gateway devices 34 and 36 then determine an updated pre-determined time which is the time at which the next measurement of the grounding resistance values shall take place. The updated pre-determined time is especially determined such that a difference between the pre-determined time and the updated pre-determined time is 20 hours or more. E.g., the updated pre-determined time is chosen such that the next measurement of grounding resistance values is taken 24 hours after the current measurement has been started.

In principle, the updated pre-determined time can also be determined by the central computation device 46 and sent to the gateway devices 34, and 36.

The updated pre-determined time is then forwarded by the gateway device 34, 36 to the plurality of measurement devices 12 to 22 (step S4 in Fig. 2).

The updated pre-determined time is especially distributed within the mesh network of measurement devices 12 to 22 by using the same relay paths which have been used for forwarding the measured grounding resistance values to the gateway devices 34 and 36, but in opposite direction. However, it is also possible that the updated pre-determined time is distributed within the mesh network using different relay paths, as long as the updated pre-determined time can be forwarded to every measurement device 12 to 22.

As soon as the updated pre-determined time is received by a measurement device 12 to 22, the respective measurement device 12 to 22 can forward a confirmation message to the associated gateway device 34, 36, the confirmation message being indicative for a successful transmission of the updated pre-determined time.

If the gateway device 34, 36 does not receive a confirmation message from all associated measurement devices 12 to 22 within a defined waiting period, the gateway device 34, 36 can forward the updated pre-determined time again.

After the updated pre-determined time has been received by the measurement devices 12 to 22, the control module 28 can set the respective measurement device 12 to 22 back to the sleep mode in which only the control module 28 or the control module 28 and a selected number of components is powered by the internal energy storage 30 such to minimize the energy consumption of the measurement devices 12 to 22.

When the updated pre-determined time is reached, the above-described steps are repeated with the pre-determined time being the updated pre-determined time. Thus, further grounding resistance values will be determined and forwarded, a further updated pre-determined time will be determined etc. In this way, the grounding system surveillance system 10 provides grounding system values on a regular basis in a highly-automated manner.

The central computation device 46 thus collects and stores a history of grounding resistance values which can be inspected by the user of the grounding system surveillance system 10.

Further, the central computation device 46 can analyze the grounding resistance values for identifying trends which allow to draw conclusions on the state of the target area 24, especially the plant structures within the target area 24.

As described before, the gateway device 34, 36 comprises a seismic sensor 42. In case a seismic event occurs in the target area 24, the grounding resistance values obtained by the measurement devices 12 to 22 can be distorted, which can negatively affect long-term evaluations of the grounding resistance values stored in the central computation device 46.

Thus, if a magnitude of a seismic activity detected by the seismic sensor 42 is larger than a magnitude threshold value stored in the memory 39 of the gateway device 34, 36, the gateway device 34, 36 forwards an alarm signal to the plurality of measurement devices 12 to 22, i.e. throughout the mesh network of measurement devices 12 to 22.

In addition, an alarm signal can also be sent to the central computation device 46 such to inform the user of the grounding resistance surveillance system about the seismic event.

Upon receiving the alarm signal, the control module 28 keeps the measurement devices 12 to 22 in the sleep mode until a re-start signal is received from the gateway device 34, 36. In consequence, the measurement devices 12 to 22 will not measure grounding resistance values until the re-start signal has been received.

It is also possible that an additional alarm signal is sent to the further device 45 which also stops measuring values upon receiving the alarm signal until a re-start signal is received.

The re-start signal is forwarded by the gateway device 34, 36 after the magnitude of the seismic activity is lowered below the magnitude threshold value again and/or after a pre-determined seismic delay time after a seismic activity with a magnitude larger than the magnitude threshold value has been detected.

If the re-start signal is forwarded at a point in time which is later than the current pre-determined time stored in the measurement devices 12 to 22, an updated pre-determined time is forwarded by the gateway device 34 and 36 together with the re-start signal.

Thus, normal operation of the grounding resistance surveillance system 10 can be resumed.

Overall, the grounding resistance surveillance system 10 according to the invention provides for an easy and reliable method for obtaining grounding resistance values. The grounding resistance surveillance system can operate in a highly-automated manner and has low demands regarding maintenance.

## Claims

1. A method for determining a grounding resistance in a target area (24), the method comprising the following steps:
a) Providing a grounding resistance surveillance system (10) with
a plurality of measurement devices (12, 14, 16, 18, 20, 22) configured for measuring a grounding resistance value and being arranged at different locations within the target area (24), and at least one gateway device (36, 38),
wherein each of the plurality of measurement devices (12, 14, 16, 18, 20, 22) is communicatively coupled to at least one further measurement device (12, 14, 16, 18, 20, 22) of the plurality of measurement devices (12, 14, 16, 18, 20, 22), and wherein at least one measurement device (12, 14, 16, 18, 20, 22) of the plurality of measurement devices (12, 14, 16, 18, 20, 22) is in direct communication with the at least one gateway device (34, 36) and at least one measurement device (12, 14, 16, 18, 20, 22) of the plurality of measurement devices (12, 14, 16, 18, 20, 22) is only in indirect communication with the at least one gateway device (34, 36) such that a mesh network of coupled measurement devices (12, 14, 16, 18, 20, 22) is formed;
b) Measuring a grounding resistance value by each of the plurality of measurement devices (12, 14, 16, 18, 20, 22) at a pre-determined time stored in a control module (28) of the respective measurement device (12, 14, 16, 18, 20, 22);
c) Forwarding the measured grounding resistance values to the gateway device (12, 14, 16, 18, 20, 22);
d) Forwarding, by the gateway device (12, 14, 16, 18, 20, 22), an updated pre-determined time to the plurality of measurement devices (12, 14, 16, 18, 20, 22); and
e) Repeating steps b) to d) at least once with the pre-determined time being the updated pre-determined time.

2. The method of claim 1, wherein the grounding resistance surveillance system (10) further comprises a central computation device (46) communicatively coupled to the at least one gateway device (34, 36) and wherein the measured grounding resistance values are sent by the at least one gateway device (34, 36) to the central computation device (46).

3. The method of claim 2, wherein the measured grounding resistance values are sent by the at least one gateway device (34, 36) to the central computation device (46) only when a measured grounding resistance value has been received by the at least one gateway device (34, 36) from each of the plurality of measurement devices (12, 14, 16, 18, 20, 22).

4. The method of any of the preceding claims, wherein the difference between the pre-determined time and the updated pre-determined time is 24 hours or more.

5. The method of any of the preceding claims, wherein the measurement devices (12, 14, 16, 18, 20, 22) forward a confirmation message to the at least one gateway device (34, 36) when the updated pre-determined time has been received.

6. The method of any of the preceding claims, wherein the at least one gateway device (12, 14, 16, 18, 20, 22) comprises a seismic sensor (42) for detecting seismic activity in the target area (24) and, if a magnitude of the seismic activity detected by the seismic sensor (42) is larger than a magnitude threshold value stored in a memory (39) of the gateway device (34, 36), the at least one gateway device (34, 36) forwards an alarm signal to the plurality of measurement devices (12, 14, 16, 18, 20, 22).

7. Grounding resistance surveillance system (10) comprising
a plurality of measurement devices (12, 14, 16, 18, 20, 22) configured for measuring a grounding resistance value and being arrangeable at different locations within a target area (24), and at least one gateway device (34, 36),
wherein each of the plurality of measurement devices (12, 14, 16, 18, 20, 22) is communicatively coupled to at least one further measurement device (12, 14, 16, 18, 20, 22) of the plurality of measurement devices (12, 14, 16, 18, 20, 22), and wherein at least one measurement device (12, 14, 16, 18, 20, 22) of the plurality of measurement devices (12, 14, 16, 18, 20, 22) is in direct communication to the at least one gateway device (34, 36) and at least one measurement device (12, 14, 16, 18, 20, 22) of the plurality of measurement devices (12, 14, 16, 18, 20, 22) is only in indirect communication to the at least one gateway device (34, 36) such that a mesh network of coupled measurement devices (12, 14, 16, 18, 20, 22) is formed,
the grounding resistance surveillance system (10) being configured to execute the method of any of the preceding claims.

8. The grounding resistance surveillance system (10) of claim 7, wherein the measurement devices (12, 14, 16, 18, 20, 22) are free from user interfaces.

9. The grounding resistance surveillance system (10) of claim 7 or 8, wherein the at least one gateway device (34, 36) of the grounding resistance surveillance system (10) is connected to an external power source (44).

10. Measurement device (12, 14, 16, 18, 20, 22) for measuring a grounding resistance value for use in a grounding resistance surveillance system (10) according to any of claims 6 to 9.
